# DEMANDE DE BREVET EUROPEEN

(11) **EP 3 618 106 A1**
(43) Date de publication de la demande: **04.03.2020**
(21) Numéro de dépôt: 19194209.3
(22) Date de dépôt: 28.08.2019
(51) Int. Cl.: H01L 23/31, H01L 21/56, H01L 21/683

(54) **BOÎTIER DE PUCE SEMI-CONDUCTEUR**

(30) Priorité: 03.09.2018 FR 1857899
(71) Demandeur: STMicroelectronics (Tours) SAS, 37100 Tours (FR)
(72) Inventeur: ORY, Olivier, 37100 TOURS (FR); JAILLET, Romain, 37100 TOURS (FR)
(74) Mandataire: Cabinet Beaumont

(57) **Abrégé**

La présente description concerne un dispositif comprenant un support (104), une couche électriquement conductrice (106) recouvrant le support, un substrat semiconducteur (108) sur la couche conductrice, et une enveloppe isolante (110).

## Description

### Domaine

La présente description concerne les dispositifs électroniques, et plus particulièrement un dispositif électronique comprenant une puce électronique logée dans un boîtier.

### Exposé de l'art antérieur

Une puce électronique est généralement définie par un substrat semiconducteur dans et sur lequel sont situés un ou plusieurs composants interconnectés, tels que des transistors, formant des circuits de la puce. Dans certaines applications, telles que la protection contre des décharges électrostatiques, la puce comprend une diode à avalanche.

Typiquement, une puce est logée dans un boîtier. Le boîtier comprend des bornes de connexion, généralement destinées à être soudées ou brasées à un circuit imprimé tel qu'un PCB ("Printed Circuit Board"). Pour qu'un dispositif comprenant une puce électronique logée dans un boîtier soit compact, on utilise souvent un boîtier de type CSP ("Chip Scale Package"), c'est-à-dire occupant une surface faible, typiquement inférieure à 1,2 fois celle du substrat de la puce.

### Résumé

Un mode de réalisation pallie tout ou partie des inconvénients des boîtiers connus de puce électronique.

Un mode de réalisation pallie tout ou partie des inconvénients des dispositifs comprenant une puce électronique dans un boîtier.

Ainsi, un mode de réalisation prévoit un dispositif comprenant un support, une couche électriquement conductrice recouvrant le support, un substrat semiconducteur sur la couche conductrice, et une enveloppe isolante recouvrant des faces avant et arrière et des flancs d'un empilement formé par le support, la couche électriquement conductrice, et le substrat.

Selon un mode de réalisation, le dispositif comprend des composants électroniques situés dans et sur le substrat.

Selon un mode de réalisation, la couche électriquement conductrice est métallique.

Selon un mode de réalisation, le substrat comprend une zone dopée définissant une électrode d'une diode à avalanche.

Selon un mode de réalisation, l'enveloppe définit un boîtier de type CSP.

Un autre mode de réalisation prévoit un procédé de réalisation d'un dispositif tel que défini ci-dessus.

Selon un mode de réalisation, le procédé comprend une étape de réalisation simultanée de plusieurs dispositifs tels que définis ci-dessus.

Selon un mode de réalisation, les substrats des dispositifs sont des portions d'une même tranche semiconductrice.

Selon un mode de réalisation, le procédé comprend une étape de formation de la couche électriquement conductrice sur une face arrière de la tranche semiconductrice.

Selon un mode de réalisation, le procédé comprend une étape de mise en place d'une plaque support côté face arrière de la couche électriquement conductrice.

Selon un mode de réalisation, le procédé comprend une étape de formation de tranchées délimitant les substrats, les tranchées atteignant de préférence un niveau situé dans la plaque support.

### Bref exposé des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente schématiquement un mode de réalisation d'un dispositif comprenant une puce électronique dans un boîtier, dans des vues 1A et 1B en coupe de côté et de dessus ;
la figure 2 est une vue en coupe illustrant schématiquement un exemple de dispositif de la figure 1 en fonctionnement ;
la figure 3 représente des étapes 3A à 3D d'un procédé de réalisation simultanée de plusieurs dispositifs de la figure 1 ; et
la figure 4 représente des étapes 4A à 4C d'un procédé de réalisation simultanée de plusieurs dispositifs de la figure 1.

### Exposé détaillé

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, des circuits de puce électronique ne sont pas représentés, les modes de réalisation décrits étant compatibles avec les circuits de puce courants.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être directement reliés (connectés) ou être reliés par l'intermédiaire d'un ou plusieurs autres éléments.

Dans la description qui suit, lorsque l'on fait référence à des qualificatifs de position absolue, tels que les termes "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures, à l'exception de la vue 1B.

Sauf précision contraire, les expressions "environ", "approximativement", "sensiblement", et "de l'ordre de" signifient à 10 % près, de préférence à 5 % près.

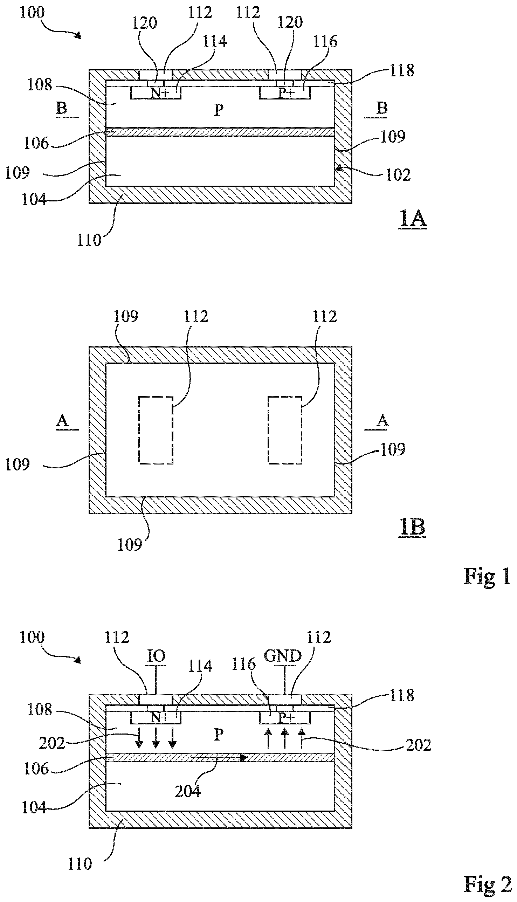

La figure 1 représente schématiquement un mode de réalisation d'un dispositif comprenant une puce électronique dans un boîtier, dans des vues 1A et 1B. Les vues 1A et 1B sont respectivement des vues en coupe de côté et de dessus selon des plans de coupe respectifs A-A et B-B.

Le dispositif 100 comprend un empilement 102 d'un support 104, d'une couche électriquement conductrice 106, et d'un substrat 108. La couche 106 est située entre le support 104 et le substrat 108.

Le support 104 est de préférence semiconducteur, de préférence en silicium, mais peut être en tout matériau conducteur ou électriquement isolant, de préférence un matériau pouvant être aminci par des moyens courants, tel que du verre, du saphir, du nitrure de gallium ou du carbure de silicium. La couche 106 est de préférence métallique, par exemple en cuivre ou en aluminium. La couche 106 recouvre la face arrière du substrat 108, de préférence intégralement. Le substrat 108 est un substrat de puce électronique, c'est-à-dire dans et sur lequel sont situés un ou plusieurs composants de circuits de puce électronique. Le substrat 108 est de préférence semiconducteur, de préférence en silicium.

De préférence, le support 104, la couche métallique 106 et le substrat 108 sont superposés de sorte que leurs bords coïncident. Les bords du support 104, de la couche métallique 106, et du substrat 108 définissent les flancs 109 de l'empilement. L'empilement 102 a de préférence la forme d'un parallélépipède. L'enveloppe recouvre alors les six faces du parallélépipède.

Le dispositif 100 comprend en outre une enveloppe isolante 110 qui enrobe l'empilement 102, c'est-à-dire que l'enveloppe 110 recouvre les faces avant et arrière et les flancs 109 de l'empilement 102, et est en contact adhérent avec les flancs 109. De préférence, l'enveloppe 110 recouvre intégralement la face arrière et les flancs 109. De préférence, l'enveloppe 110 est traversée du côté de la face avant par des bornes de connexion 112. De préférence, l'enveloppe 110 recouvre intégralement la face avant de l'empilement 102 à l'exception des bornes de connexion 112. L'enveloppe 110 définit ainsi un boîtier de puce électronique. Le boîtier est de préférence de type CSP.

La présence du support 104 permet de prévoir un substrat 108 mince, par exemple d'épaisseur inférieure à environ 150 µm ou inférieure à 150 µm, de préférence inférieure à environ 100 µm ou inférieure à 100 µm, tout en étant facilement manipulable par les moyens courants.

Grâce à l'association d'un substrat mince et d'une couche conductrice sur la face arrière du substrat mince, le fonctionnement du dispositif est amélioré par rapport aux dispositifs n'ayant pas à la fois un substrat mince et une couche métallique sur la face arrière, comme ceci est décrit ci-après dans le cas de l'exemple représenté.

Dans l'exemple représenté, le substrat 108 est par exemple dopé de type P. Une zone dopée 114 de type N et une zone 116 dopée de type P disjointes sont situées côté face avant du substrat 108. Les zones 114 et 116 ont de préférence des niveaux de dopage (N+, P+) supérieurs à celui du substrat 108. Le substrat 108 et la zone 114 peuvent former entre eux la jonction PN d'une diode à avalanche.

De préférence, l'empilement 102 comprend une couche isolante 118 recouvrant le substrat 108. Dans l'exemple représenté, la couche 118 est traversée par des régions électriquement conductrices 120, par exemple métalliques, s'étendant à partir des régions 114 et 116 jusqu'aux bornes 112.

La figure 2 est une vue en coupe illustrant le fonctionnement de l'exemple du dispositif 100 représenté en figure 1.

Les bornes de connexion 112 sont par exemple reliées à une borne d'application d'un potentiel de référence, par exemple une masse GND, et à une borne IO à protéger contre des décharges électrostatiques. En cas de décharge électrostatique provoquant une hausse du potentiel de la borne IO, la jonction PN entre la zone dopée 114 et le substrat 108 entre en avalanche. Un courant circule de la zone 114 à la zone 116, ce qui évacue la décharge vers la masse.

Du fait que le substrat 108 est mince et recouvre la couche métallique 106, le courant circule verticalement entre chacune des zones 114 et 112 et la couche métallique 106 (flèche 202). Le courant est conduit latéralement par la couche métallique 106 (flèche 204) de l'aplomb de la zone 114 à l'aplomb de la zone 112. On obtient une répartition uniforme du courant sortant de la zone 114. Cette répartition permet d'évacuer vers la masse un courant d'intensité plus élevée que lorsque le substrat n'est pas mince ou est dépourvu de couche métallique sous sa face arrière. En effet, avec un substrat non mince, ou sans couche métallique, le courant circulerait latéralement entre les zones 114 et 116 en passant par le substrat. Le courant sortirait de la zone 114 en se concentrant du côté de la zone 114 proche de la zone 116. Une telle concentration limiterait l'intensité maximale du courant.

Le mode de réalisation des figures 1 et 2 est compatible avec la plupart des circuits de puce électronique. La couche 112 peut comprendre des pistes d'interconnexion entre les composants des circuits, tels que des transistors, situés dans et sur le substrat 106. Les circuits sont connectés à des régions conductrices 120 en contact avec des bornes 120.

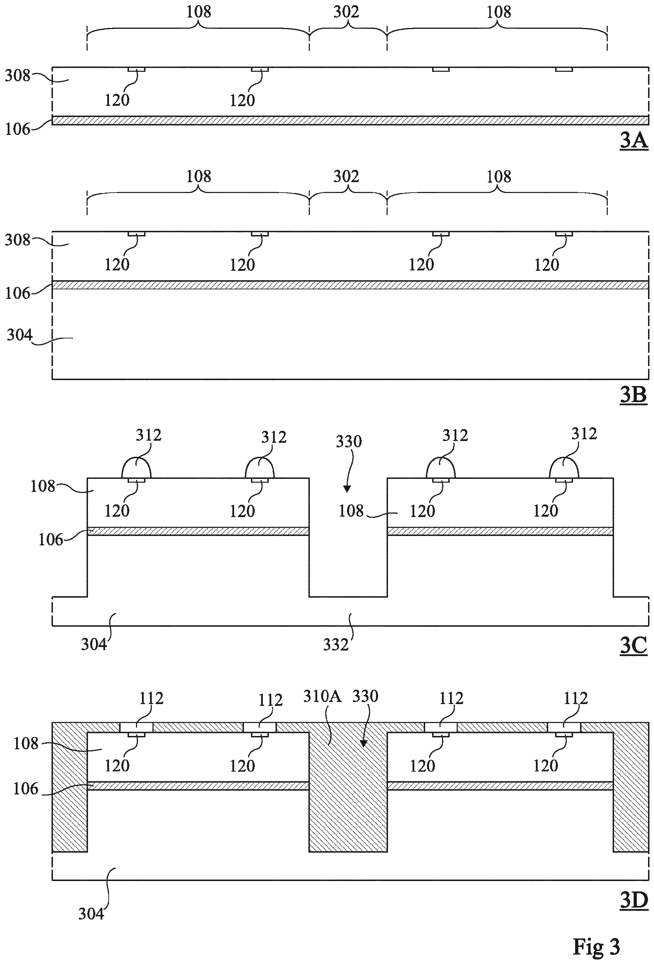

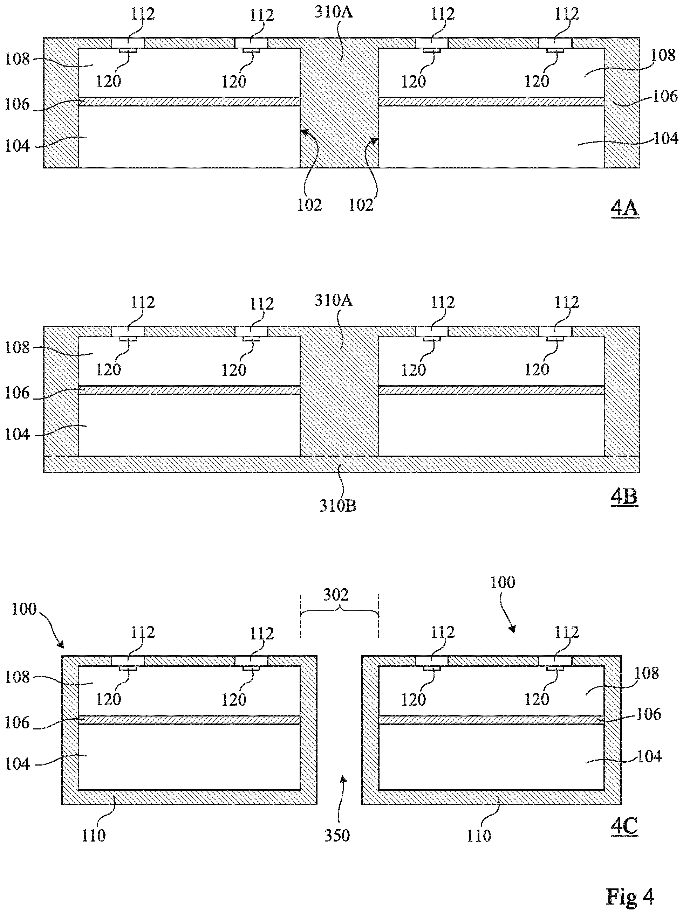

Les figures 3 et 4 sont des vues en coupe, partielles et schématiques, illustrant des étapes 3A à 3D et 4A à 4C de mise en oeuvre d'un procédé de réalisation simultanée de plusieurs dispositifs du type de celui de la figure 1.

A l'étape 3A, on prévoit une tranche semiconductrice 308. La tranche 308 est destinée à être divisée en substrats 108 individuels. Chaque futur substrat 108 correspond à une partie de la tranche. Les futurs substrats 108 sont de préférence disjoints, par exemple séparés par des bandes 302. A titre d'exemple, les futurs substrats 108 sont disposés en matrice.

On forme des circuits de puce électronique dans et sur les futurs substrats 108. Sur la face avant de la tranche 308, on forme des régions conductrices 120 connectées aux circuits. Les régions 120 sont de préférence accessibles depuis la face avant. A titre d'exemple, les régions 120 sont situées dans une couche isolante non représentée recouvrant la face avant. La couche isolante comprend d'éventuelles pistes d'interconnexion.

Afin de donner à la tranche 308 l'épaisseur des futurs substrats 108, on procède par exemple à un amincissement de la tranche 308, de préférence après la formation des circuits.

On recouvre ensuite la face arrière de la tranche 308 d'une couche conductrice 106, de préférence métallique. La couche 106 a de préférence une épaisseur entre 0.5 µm et 5.0 µm. De préférence, cette épaisseur est choisie en fonction de la conductivité électrique du matériau de la couche 106.

A l'étape 3B, on met en place une plaque support 304 sous la face arrière de la couche 106. Les futurs supports 104 sont des parties de la plaque 304. L'épaisseur de la plaque 304 est de préférence supérieure à celle des futurs supports 104. La plaque 304 est par exemple collée à la couche métallique 106 au moyen d'un adhésif. De préférence, l'adhésif est réparti sur toute la surface de la plaque 304.

A l'étape 3C, on forme des plots métalliques 312 recouvrant les régions conductrices 120. On creuse ensuite des tranchées 330 délimitant les substrats 108. Les tranchées 330 s'étendent de la face avant du substrat 108 jusqu'à un niveau situé dans la plaque support 304. La profondeur des tranchées 330 est de préférence supérieure à la hauteur des futurs empilements 102. On laisse en place des portions 332 de la plaque 304 en-dessous des tranchées.

A l'étape 3D, on recouvre l'ensemble de la structure obtenue à l'étape 3C d'un isolant 310A remplissant les tranchées 330. On retire ensuite tous les éléments situés au-dessus d'un niveau passant par les plots métalliques 312, par exemple par polissage. Il en résulte des bornes de connexion 112 correspondant aux parties restantes des plots 312. L'isolant 310A recouvre la surface supérieure du substrat 108 à l'exception des emplacements des bornes 112. Les bornes 112 affleurent la face supérieure de l'isolant 310A.

A l'étape 4A, on procède au polissage de la face arrière de la plaque, au moins jusqu'à avoir retiré complètement les régions 332 de la plaque 304 qui étaient situées sous les tranchées 330 avant polissage. L'isolant 310A affleure alors la face inférieure de la structure obtenue après polissage. On a ainsi obtenu les empilements 102, reliés mécaniquement entre eux par l'adhérence de l'isolant 310 sur leurs flancs.

A l'étape 4B, on forme une couche d'un isolant 310B recouvrant la face arrière de la structure obtenue à l'étape 4A. L'isolant 310B est de préférence le même matériau que l'isolant 310A, par exemple une résine.

A l'étape 4C, on découpe la structure obtenue à l'étape 4B en dispositifs 100 individuels. Pour cela, On retire l'isolant 310A dans des régions 350 sur toute la hauteur de la structure, par exemple par découpe. Les régions 350 sont situées dans les bandes 302 et ont une largeur inférieure à celle des tranchées 330, en sorte de laisser des portions de l'isolant 310A recouvrant les flancs des empilements 102. Chaque enveloppe 110 comprend les portions d'isolant 310A recouvrant la face avant et les flancs de l'empilement 102 correspondant, et la portion d'isolant 310B recouvrant la face arrière de cet empilement.

Divers modes de réalisation et variantes ont été décrits. Ces divers modes de réalisation et variantes sont combinables et d'autres variantes apparaitront à l'homme de l'art. Enfin, la mise en oeuvre pratique des modes de réalisation et variantes décrits est à la portée de l'homme du métier à partir des indications fonctionnelles données ci-dessus.

## Revendications

1. Dispositif comprenant un support (104), une couche électriquement conductrice (106) recouvrant le support, un substrat semiconducteur (108) sur la couche conductrice, et une enveloppe isolante (110) recouvrant des faces avant et arrière et des flancs d'un empilement formé par le support (104), la couche électriquement conductrice (106), et le substrat (108).

2. Dispositif selon la revendication 1, comprenant des composants électroniques situés dans et sur le substrat.

3. Dispositif selon la revendication 1 ou 2, dans lequel la couche électriquement conductrice (106) est métallique.

4. Dispositif selon l'une quelconque des revendications 1 à 3, dans lequel le substrat (108) comprend une zone dopée (114) définissant une électrode d'une diode à avalanche.

5. Dispositif selon l'une quelconque des revendications 1 à 4, dans lequel l'enveloppe (110) définit un boîtier de type CSP.

6. Procédé de réalisation d'un dispositif selon l'une quelconque des revendications 1 à 5.

7. Procédé selon la revendication 6, comprenant une étape de réalisation simultanée de plusieurs dispositifs selon l'une quelconque des revendications 1 à 5.

8. Procédé selon la revendication 7, dans lequel les substrats (108) des dispositifs sont des portions d'une même tranche semiconductrice (308).

9. Procédé selon la revendication 8, comprenant une étape de formation de la couche électriquement conductrice (116) sur une face arrière de la tranche semiconductrice (308).

10. Procédé selon la revendication 9, comprenant une étape de mise en place d'une plaque support (304) côté face arrière de la couche électriquement conductrice (116).

11. Procédé selon la revendication 10, comprenant une étape de formation de tranchées (330) délimitant les substrats (108), les tranchées atteignant de préférence un niveau situé dans la plaque support (304).
